# EUROPEAN PATENT APPLICATION

(11) **EP 4 775 720 A1**
(43) Date of publication of application: **15.07.2026**
(21) Application number: 26151320.4
(22) Date of filing: 12.01.2026
(51) Int. Cl.: C30B 29/36, C30B 33/06, H10P 10/00

(54) **EPITAXIAL LAYER ON DIRECT BONDED SUBSTRATE AND METHOD OF MANUFACTURING THE SAME**

(30) Priority: 14.01.2025 SE 2550019
(71) Applicant: STMicroelectronics International N.V., 1228 Plan-les-Ouates, Geneva (CH)
(72) Inventor: MAGNUSSON LINDGREN, Bjorn, 60379 Norrköping (SE); ISACSON, Mathias, 60379 Norrköping (SE)
(74) Representative: Studio Torta S.p.A.

(57) **Abstract**

The present disclosure is directed to a stacked assembly including a polycrystalline Silicon Carbide (SiC) substrate on which a monocrystalline SiC layer and one or more epitaxial layers are stacked. The one or more epitaxial layers are completely separated from the polycrystalline SiC substrate by the monocrystalline layer, which is stacked on the polycrystalline SiC substrate such that the monocrystalline SiC layer is between the one or more epitaxial layers and a respective surface of the polycrystalline SiC substrate. The present disclosure is further directed to one or more embodiments of methods of manufacturing one or more embodiments of the stacked assemblies.

## Description

### BACKGROUND

### Technical Field

The present invention is directed to silicon-carbide (SiC) based substrates and wafers on which a monocrystalline SiC layer is formed such that an epitaxial layer is formed on the SiC monocrystalline layer.

### Description of the Related Art

The semiconductor industry has been showing considerable interest in silicon carbide (SiC), in particular for the manufacture of electronic devices or components (*e*.*g*., diodes, transistors, or other similar power applications).

Development and manufacture of silicon carbide based electronic devices are limited by factors such as electrical and mechanical properties from forming silicon carbide wafers. After being processed and refined, many manufactured silicon carbide wafers have one or more epitaxial layers formed on a respective surface of the silicon carbide wafers. For example, in direct bonded silicon-carbide (SiC) substrates, a monocrystalline SiC layer is bonded to a polycrystalline SiC substrate. After the monocrystalline layer has been bonded to the silicon-carbide substrate, one or more epitaxial layers are formed on the monocrystalline layer by placing the direct bonded SiC substrate, which includes the monocrystalline SiC layer bonded to the polycrystalline SiC substrate. The one or more epitaxial layers are formed by placing the direct bonded SiC substrate into an epitaxial growth chamber of an epitaxial layer formation tool. The epitaxial growth chamber is heated up to a selected temperature at which point a silicon-based gas, a carbon-based gas, and a hydrogen gas is introduced into the epitaxial growth chamber resulting in forming a silicon-carbide epitaxial layer on the monocrystalline SiC layer bonded to the polycrystalline SiC substrate of the direct bonded SiC substrate. However, while the epitaxial growth chamber in which the direct bonded SiC substrate is heated, the monocrystalline SiC layer is deteriorated, partially removed, or completely removed such that regions of a surface of the polycrystalline SiC layer are exposed from the monocrystalline SiC layer resulting in forming the epitaxial layer on the regions of the surface of the polycrystalline SiC layer exposed from the monocrystalline SiC layer. When the epitaxial layer is formed on these exposed regions, the epitaxial layer includes physical characteristics (*i.e.,* crystalline structure) of the polycrystalline SiC substrate at the regions exposed from the monocrystalline SiC layer. Alternatively, in some situations, the entirety of the monocrystalline SiC layer is deteriorated or removed resulting in an entirety of a surface of the polycrystalline SiC substrate on which the monocrystalline SiC layer was previously being exposed. In these situations, when the epitaxial layer is then formed, the epitaxial is completely formed on the surface of the polycrystalline SiC substrate as the monocrystalline SiC layer is no longer present. When the monocrystalline SiC substrate is partially removed or completely removed from the surface of the polycrystalline SiC substrate resulting in the epitaxial layer being formed directly on the surface of the polycrystalline substrate, the manufactured direct bonded SiC substrate is not within selected tolerances due to the epitaxial layer being in direct contact with the surface of the polycrystalline layer resulting in these manufactured directed bonded SiC substrate being waste and increasing yield loss.

### BRIEF SUMMARY

The present disclosure relates to a method and a device as defined in the annexed claims, more particularly to silicon-carbide (SiC) based substrates and wafers on which a monocrystalline SiC layer is formed such that an epitaxial layer is formed on the monocrystalline SiC layer to not be in contact with the polycrystalline SiC substrate.

At least one embodiment of a direct bonded SiC substrate of the present disclosure includes: a polycrystalline SiC substrate including a first surface and a second surface opposite to the first surface; a monocrystalline SiC layer directly and physically bonded to the second surface of the polycrystalline SiC substrate; one or more epitaxial layers on the monocrystalline SiC layer, the one or more epitaxial layers are completely and fully separate and spaced apart from the polycrystalline SiC substrate by the monocrystalline SiC layer.

At least one embodiment of a method of manufacturing a direct bonded SiC substrate of the present disclosure includes: forming a direct bonded SiC substrate including: forming a polycrystalline SiC substrate including a first surface and a second surface opposite to the first surface; forming a monocrystalline SiC substrate including a third surface and a fourth surface opposite to the third surface; bonding the monocrystalline SiC substrate to the polycrystalline SiC substrate; after bonding the monocrystalline SiC substrate to the polycrystalline SiC substrate, removing a first portion of the monocrystalline SiC substrate leaving a second portion remaining bonded to the polycrystalline SiC substrate forming a monocrystalline SiC layer stacked on the polycrystalline SiC substrate, the monocrystalline SiC layer fully and completely overlaps the polycrystalline SiC substrate; forming one or more epitaxial layers on the monocrystalline SiC layer stacked on the polycrystalline SiC substrate including: inserting the direct bonded SiC substrate into an epitaxial layer formation chamber of an epitaxial layer formation tool; heating up the epitaxial layer formation temperature from a first temperature to a second temperature; and introducing a carry gas into the epitaxial layer formation chamber and another gas into the epitaxial layer formation chamber forming the one or more epitaxial layers on the monocrystalline SiC layer after forming the one or more epitaxial layers on the monocrystalline SiC layer, removing a stacked assembly from the epitaxial layer formation chamber, and the stacked assembly includes the polycrystalline SiC substrate, the monocrystalline SiC layer, and the one or more epitaxial layers in a stacked configuration.

### BRIEF DESCRIPTION OF THE SEVERAL VIEWS OF THE DRAWINGS

For a better understanding of the embodiments, reference will now be made by way of example to the accompanying drawings. In the drawings, identical reference numbers identify the same or similar elements or acts unless the context indicates otherwise. The sizes and relative proportions of the elements in the drawings are not necessarily drawn to scale. For example, some of these elements can be enlarged and positioned to improve drawing legibility.
Figure 1 is directed to a perspective view of a polycrystalline SiC base substrate or wafer.
Figure 2 is directed to a perspective side view of a direct bonded silicon-carbide (SiC) substrate including the polycrystalline SiC base substrate or wafer as shown in Figure 1.
Figure 3 is directed to a perspective view of a direct bonded silicon-carbide (SiC) substrate including the polycrystalline SiC base substrate or wafer as shown in Figure 1.
Figure 4 is directed to a perspective view of a direct bonded silicon-carbide (SiC) substrate as shown in Figure 2 on which one or more epitaxial layers are formed in accordance with some embodiments of the present disclosure.
Figure 5 is directed to a perspective view of a direct bonded silicon-carbide (SiC) substrate as shown in Figure 3 on which one or more epitaxial layers are formed in accordance with some embodiments of the present disclosure.
Figure 6 is directed to a flowchart of an embodiment of a method of manufacturing the embodiment of the stacked assembly as shown in Figure 4 in accordance with some embodiments of the present disclosure.
Figures 7A-7E are directed to side views and a perspective view of respective steps of the flowchart of the embodiment of the method of manufacturing the embodiment of the stacked assembly as shown in Figure 4 in accordance with some embodiments of the present disclosure.
Figure 8 is directed to a flowchart of an alternative embodiment of a method of manufacturing the alternative embodiment of the stacked assembly as shown in Figure 5 in accordance with some embodiments of the present disclosure.
Figures 9A-9C are directed to side views and a perspective view of respective steps of the flowchart of the alternative embodiment of the method of manufacturing the alternative embodiment of the stacked assembly as shown in Figure 5 in accordance with some embodiments of the present disclosure.

### DETAILED DESCRIPTION

In the following description, certain details are set forth in order to provide a thorough understanding of various embodiments of devices, methods and articles. However, one of skill in the art will understand that other embodiments can be practiced without these details. In other instances, well-known structures and methods associated with, for example, silicon carbide substrates or layers (*e*.*g*., polycrystalline silicon carbide, monocrystalline silicon carbide, etc.), semiconductor fabrication processes, etc., have not been shown or described in detail in some figures to avoid unnecessarily obscuring descriptions of the embodiments.

Unless the context requires otherwise, throughout the specification and claims which follow, the word "comprise" and variations thereof, such as "comprising," and "comprises," are to be construed in an open, inclusive sense, that is, as "including, but not limited to."

Reference throughout this specification to "one embodiment," or "an embodiment" means that a particular feature, structure or characteristic described in connection with the embodiment is included in at least one embodiment. Thus, the appearances of the phrases "in one embodiment," or "in an embodiment" in various places throughout this specification are not necessarily referring to the same embodiment, or to all embodiments. Furthermore, the particular features, structures, or characteristics can be combined in any suitable manner in one or more embodiments to obtain further embodiments.

The semiconductor industry has been showing considerable interest in silicon carbide (SiC), in particular for the manufacture of electronic devices or components (*e*.*g*., diodes, transistors, or other similar power applications).

Generally, development and manufacture of silicon carbide based electronic devices are limited by factors such as electrical and mechanical properties from forming silicon carbide wafers. After being processed and refined, many manufactured silicon carbide wafers have one or more epitaxial layers formed on a respective surface of the silicon carbide wafers. For example, in direct bonded silicon-carbide (SiC) substrates, a monocrystalline SiC layer is bonded to a polycrystalline SiC substrate. After the monocrystalline layer has been bonded to the silicon-carbide substrate, one or more epitaxial layers are formed on the monocrystalline layer by placing the direct bonded SiC substrate, which includes the monocrystalline SiC layer bonded to the polycrystalline SiC substrate. The one or more epitaxial layers are formed by placing the direct bonded SiC substrate into an epitaxial growth chamber of an epitaxial layer formation tool. The epitaxial growth chamber is heated up to a selected temperature at which point a silicon-based gas, a carbon-based gas, and a hydrogen gas is introduced into the epitaxial growth chamber resulting in forming a silicon-carbide epitaxial layer on the monocrystalline SiC layer bonded to the polycrystalline SiC substrate of the direct bonded SiC substrate. However, while the epitaxial growth chamber in which the direct bonded SiC substrate is heated, the monocrystalline SiC layer is deteriorated, partially removed, or completely removed such that regions of a surface of the polycrystalline SiC layer are exposed from the monocrystalline SiC layer resulting in forming the epitaxial layer on the regions of the surface of the polycrystalline SiC layer exposed from the monocrystalline SiC layer. When the epitaxial layer is formed on these exposed regions, the epitaxial layer includes physical characteristics (*i.e.,* crystalline structure) of the polycrystalline SiC substrate at the regions exposed from the monocrystalline SiC layer. Alternatively, in some situations, the entirety of the monocrystalline SiC layer is deteriorated or removed resulting in an entirety of a surface of the polycrystalline SiC substrate on which the monocrystalline SiC layer was previously being exposed. In these situations, when the epitaxial layer is then formed, the epitaxial is completely formed on the surface of the polycrystalline SiC substrate as the monocrystalline SiC layer is no longer present. When the monocrystalline SiC substrate is partially removed or completely removed from the surface of the polycrystalline SiC substrate resulting in the epitaxial layer being formed directly on the surface of the polycrystalline substrate, the manufactured direct bonded SiC substrate is not within selected tolerances due to the epitaxial layer being in direct contact with the surface of the polycrystalline layer resulting in these manufactured directed bonded SiC substrate being waste and increasing yield loss. The present disclosure is directed to providing one or more embodiments of a direct bonded

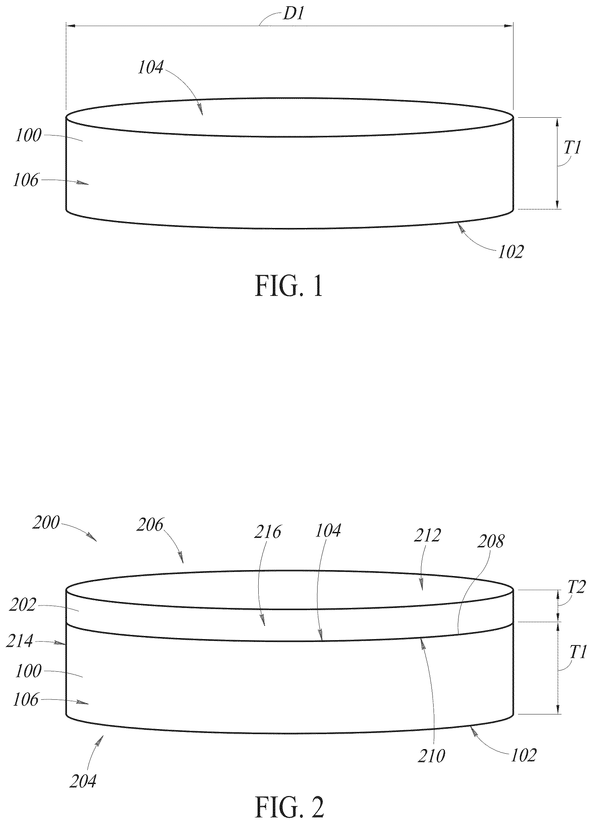

Figure 1 is a perspective view of a polycrystalline silicon-carbide (SiC) base substrate 100, which can be a polycrystalline or base substrate, before a monocrystalline layer and one or more epitaxial have been coupled, bonded, or formed to or on the polycrystalline SiC base substrate 100. The polycrystalline SiC base substrate 100 has the diameter D1. In some situations, the diameter D1 is within a range from 150 millimeters (mm) to 300 millimeters (mm), or is equal to the upper and lower ends of this range. For example, in at least some situations, the diameter D1 is equal to 150 millimeters (mm) or is equal to 300 millimeters (mm). The polycrystalline SiC base substrate 100 includes a first surface 102, a second surface 104 opposite to the first surface 102, and a sidewall 106 that extends from the first surface 102 to the second surface 104 and is transverse to the first and second surfaces 102, 104.

A first thickness T1, which is referred to as a first dimension, of the polycrystalline SiC base substrate 100 extends from the first surface 102 to the second surface 104 of the polycrystalline SiC substrate 100. In at least some situations, the first thickness T1 is within the range of 150 micrometers (µm) to 1000 micrometers (µm) or is equal to the lower and upper ends of this range. In some situations, the thickness T1 is greater than 1000 micrometers (µm) or is less than 150 micrometers (µm). In other words, the first thickness T1 of the polycrystalline SiC base substrate 100 is selected or manufactured to have the first thickness T1 depending on a type of semiconductor device or package that is to be manufactured within a semiconductor manufacturing plant (FAB).

In some situations, the polycrystalline SiC base substrate 100 has a resistivity within a range from 3 mohm-cm (milliohm-centimeter) to 30 mohm-cm (milliohm-centimeter), or is equal to the upper and lower ends of this range.

The second surface 104 of the polycrystalline SiC base substrate 100 has a roughness less than or equal to 200 nm. In some situations, the second surface 104 of the polycrystalline SiC base substrate 100 has a roughness in the range of 10 nm to 50 nm, or is equal to the lower and upper ends of this range (*e.g*., the roughness is equal to 10 nm or is equal to 50 nm). This roughness of the second surface 104 is obtained by polishing the second surface 104.

Figure 2 is directed to a perspective view of a direct bonded SiC substrate 200 including the polycrystalline SiC base substrate 100 as shown in Figure 1. The direct bonded SiC substrate 200 includes the polycrystalline SiC base substrate 100 and a monocrystalline SiC layer 202 that is on the polycrystalline SiC base substrate 100.

The direct bonded SiC substrate 200 includes a first side 204 and a second side 206 that is opposite to the first side 204. The direct bonded SiC substrate 200 further a bonding region 208 at which the monocrystalline SiC layer 202 is directly and physically bonded to the polycrystalline SiC base substrate 100. In this situation, the monocrystalline SiC layer 202 is directly and physically bonded to the second surface 104 of the polycrystalline SiC base substrate 100.

The polycrystalline SiC base substrate 100 is referred to as a polycrystalline silicon carbide substrate, a polycrystalline silicon carbide wafer, a polycrystalline silicon carbide layer, or can be referred to in some other suitable manner. The monocrystalline silicon carbide (SiC) layer 202 may be referred to as a monocrystalline silicon carbide substrate, a monocrystalline silicon carbide wafer, a monocrystalline silicon carbide layer, or can be referred to in some other suitable manner.

In at least one situation, the monocrystalline SiC layer 202 has a density equal to 3.21 g/cm³. In at least one situation, the polycrystalline SiC base substrate 100 has a density within a range ranging from 3.1 g/cm³ to 3.2 g/cm³, or the density is equal to the upper and lower ends of this range. In at least one situation, the polycrystalline SiC base substrate 100 has a density within a range ranging from 3.15 g/cm³ to 3.2 g/cm³, or the density is equal to the upper and lower ends of this range.

As shown in Figure 2, the first surface 102 of the polycrystalline SiC base substrate 100 is at the first side 204 of the direct bonded SiC substrate 200. The monocrystalline SiC layer 202 includes a third surface 210 and a fourth surface 212 opposite to the third surface 210. The fourth surface 212 of the monocrystalline SiC layer 202 is at the second side 206 of the direct bonded SiC substrate 200, and the third surface 210 of the monocrystalline SiC layer is directly and physically bonded to the second surface 104 of the polycrystalline SiC base substrate 100.

The monocrystalline SiC layer 202 has a second thickness T2, which is referred to as a second dimension. The second thickness T2 extends from the third surface 210 of the monocrystalline SiC layer 202 to the fourth surface 212 of the monocrystalline SiC layer 202. The second thickness T2 of the monocrystalline SiC layer 202 is, in an embodiments, less than the first thickness T1 of the polycrystalline SiC base substrate 100. In at least one situation, the second thickness T2 of the monocrystalline SiC layer 202 is within the range 0.3 micrometers (µm) to 2 micrometers (µm), or is equal to the upper and lower ends of this range (*e.g.,* the second thickness T2 is equal to 0.3 micrometers (µm) or is equal to 2 micrometer (µm)). In some situations, the second thickness T2 is within the range of 0.3 micrometers (µm) to 1 micrometers (µm), or is equal to the upper and lower ends of this range (*e.g.,* the second thickness T2 is equal to 0.3 micrometers (µm) or is equal to 1 micrometer (µm)). In some situations, the second thickness T2 of the monocrystalline SiC layer 202 is equal to 0.5 micrometers (µm). In some situations, the second thickness T2 is within a range from 20 micrometers (µm) to 200 micrometers (µm), or is equal to the upper and lower ends of this range (*e.g.,* the second thickness T2 is equal to 20 micrometers (µm) or is equal to 200 micrometers (µm)). In some situations, the second thickness T2 is equal to 120 micrometers (µm).

In some situations, the first thickness T1 of the polycrystalline SiC base substrate 100 is within a range from 150 micrometers (µm) to 1500 micrometers (µm), or is equal to the upper and lower ends of this range (*e.g.,* the first thickness T1 is equal to 150 micrometers (µm) or is equal to 1000 micrometers (µm)). In some situations, the first thickness T1 is less than or equal to 1 millimeter (mm).

In some situations, a sum of the first thickness T1 and the second thickness T2 is within a range from 200 micrometers (µm) to 1500 micrometers (µm), or is equal to the upper and lower ends of this range. For example, in some situations, the sum of first thickness T1 and the second thickness T2 is equal to 200 micrometers (µm), is equal to 1500 micrometers (µm), or is equal to some other thickness between 200 and 1500 micrometers (µm). In some situations, the sum of the first thickness T1 and the second thickness T2 is equal to 250 micrometers (µm), is equal to 500 micrometers (µm), or is equal to some other thickness between 250 micrometers (µm) and 500 micrometers (µm). In some situations, the sum of the first thickness T1 and the second thickness T2 is equal to 700 micrometers (µm), is equal to 800 micrometers (µm), or is equal to some other thickness between 700 micrometers (µm) and 800 micrometers (µm).

In at least one situation, the monocrystalline SiC layer 202 has a resistivity less than 25 mohm-cm or preferably equal to 18 mohm-cm or in the range from 15 mohom-cm to 20 mohom-cm or equal to the upper and lower ends of this range. In at least one situation, the polycrystalline SiC base substrate 100 has a void density less than or equal to 3%. In the direct bonded SiC substrate as shown in Figure 2, the bonding region 208 is present between the second surface 104 of the polycrystalline SiC base substrate 100 and second surface 104 of the monocrystalline SiC layer 202, and the bonding region 208 is a location at which the second surface 104 of the polycrystalline SiC base substrate 100 is directly and physically coupled to or bonded to the monocrystalline SiC layer 202. In some situations, the monocrystalline SiC layer 202 is directly and physically bonded to the polycrystalline SiC base substrate 100 by utilizing a surface activated bonding (SAB) technique. For example, in the surface activated bonding technique the second surface 104 of the polycrystalline SiC base substrate 100 and the third surface 210 of the monocrystalline SiC layer 202 is bombarded by Argon (Ar) ions or neutral atoms (*e*.*g*., a beam of particles that is Argon (Ar), is neutral atoms, or is some other similar or like type of particle or atom that is suitable) in an ultra-high vacuum to clean and activate the second surface 104 of the polycrystalline SiC base substrate 100 and the third surface 210 of the monocrystalline SiC layer 202. After the second surface 104 of the polycrystalline SiC base substrate 100 and the third surface 210 of the monocrystalline SiC layer 202 are cleaned and activated, the second surface 104 of the polycrystalline SiC base substrate 100 and the third surface 210 of the monocrystalline SiC layer 202 are bonded spontaneously by contacting the second surface 104 of the polycrystalline SiC base substrate 100 with the third surface 210 of the monocrystalline SiC layer 202. This contacting of the second surface 104 of the polycrystalline SiC base substrate 100 with the third surface 210 of the monocrystalline SiC layer 202 can be done without heat treatment.

The direct bonded SiC substrate 200 further includes at least one sidewall 214 (*e.g.,* curved sidewall as shown in Figure 2). The at least one sidewall 214 of the direct bonded SiC substrate 200 is defined by the sidewall 106 of the polycrystalline SiC base substrate 100 and a sidewall 216 of the monocrystalline SiC layer 202. The at least one sidewall 214 is defined by the sidewall 106 of the polycrystalline SiC base substrate 100 and the sidewall 216 of the monocrystalline SiC layer 202 as these respective sidewalls 106, 216 are coplanar and flush with each other. In other words, the at least one sidewall 214 includes and is defined by the respective sidewalls 106, 216 of the polycrystalline SiC base substrate 100 and the monocrystalline SiC layer 202.

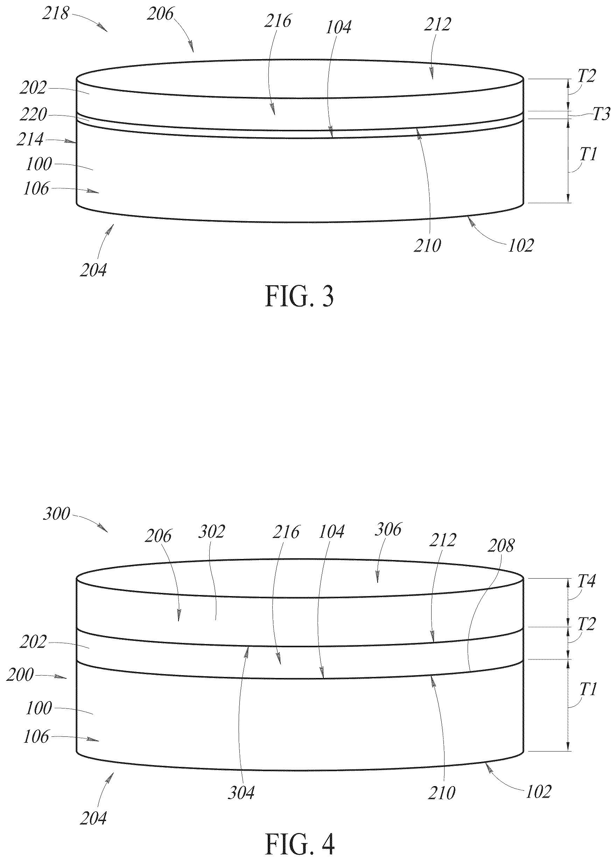

While not shown in Figure 2, in some alternative versions (*see, e.g.,* Figure 3 of the present disclosure as discussed in detail later herein) of the direct bonded SiC substrate 200, a silicon oxide (*e*.*g*., SiO₂) layer is present at the bonding region 208 such that the silicon oxide layer is between the polycrystalline SiC base substrate 100 and the monocrystalline SiC layer 202. The silicon oxide layer between the polycrystalline SiC base substrate 100 and the monocrystalline SiC layer 202 can further facilitate coupling or bonding the monocrystalline SiC layer 202 to the polycrystalline SiC base substrate 100.

In some situations, the second surface 104 of the polycrystalline SiC base substrate 100 has a roughness less than or equal to 200 nm. In some situations, the second surface 104 of the polycrystalline SiC base substrate 100 has a roughness in a range from 10 nm to 50 nm, or is equal to the lower and upper ends of this range (*e.g.,* a roughness is equal to 10 nm or is equal to 50 nm). This roughness of the second surface 104 can be obtained by polishing the second surface 104.

In some situations, the third surface 210 of the monocrystalline SiC layer 202 has a roughness less than or equal to 200 nm. In some situations, the third surface 210 of the monocrystalline SiC layer 202 has a roughness in a range from 10 nm to 50 nm, or is equal to the lower and upper ends of this range (*e.g.,* the roughness is equal to 10 nm or is equal to 50 nm). This roughness of the third surface 210 is obtained by polishing the third surface 210.

The fourth surface 212 of the monocrystalline layer 202 may have a roughness less than or equal to 200 nm. In some embodiments, the fourth surface 212 of the monocrystalline layer 202 may have a roughness in the range of 10-50 nm and is equal to the lower and upper ends of this range (*e.g.,* the roughness is equal to 10 nm or is equal to 50 nm). This roughness of the fourth surface 212 can be obtained by polishing or planarizing the fourth surface 212. In some embodiments, a roughness at the first surface 102 of the polycrystalline SiC base substrate 100 is greater than or equal to the roughness of the second surface 104 of the polycrystalline SiC base substrate 100. This roughness of the second surface 104 can be obtained by polishing or planarizing the second surface 102. The monocrystalline SiC layer 202 having a low roughness (*i.e.,* in a range of 1-5 Anstrom (Å)) results in the fourth surface of the monocrystalline SiC layer 202 having minimal cratering, undulations, or divots along the fourth surface 212. This prevents forming gaps or air gaps between the fourth surface 212 of the monocrystalline SiC layer 202 and other additional layers (*i.e*., one or more epitaxial layers 302) that are formed on and along the fourth surface 212 of the monocrystalline layer 202). The monocrystalline SiC layer 202 further includes other physical characteristics such as a crystalline structure of 4H polytype with either an on-axis (0001) plane or an off-axis with an angle of 4-degreees. Both the on-axis or the off-axis 4H polytype crystalline structures have a min and max of +/- 0.5-degrees. In addition, these 4H polytype crystalline structures have a basal plane dislocation less than 500-cm² (centimeters squared). These physical characteristics of the monocrystalline SiC layer 202 are transferred to the one or more epitaxial layers 302 that are formed on the fourth surface 212 of the monocrystalline SiC layer 202.

The direct bonded SiC substrate 200 or a portion of the direct bonded SiC substrate 200 is generally further processed or utilized to manufacture a semiconductor device or a semiconductor package in a semiconductor manufacturing plant (FAB). For example, the direct bonded SiC substrate 200 is utilized to form a vertical device that includes the direct bonded SiC substrate or a portion of the direct bonded SiC substrate 200. For example, in at least some situation, additional layers are formed on the fourth surface 212 of the monocrystalline SiC layer 202 (*see, e*.*g*., Figure 4 of the present disclosure as discussed in detail later herein).

Figure 3 is directed to a perspective view of a direct bonded SiC substrate 218 including the polycrystalline SiC base substrate 100 and the monocrystalline SiC layer 202. The direct bonded SiC substrate 218 includes several of the same or similar features of the direct bonded SiC substrate 200 as shown in Figure 2 of the present disclosure. Accordingly, these same or similar features between the direct bonded SiC substrate 218 as shown in Figure 3 and the direct bonded SiC substrate 200 as shown in Figure 2 are provided with the same or similar references numerals. Furthermore, for the sake of brevity and simplicity of the present disclosure, the following discussion with respect to the direct bonded SiC substrate 218 as shown in Figure 3 will focus on differences or additions relative to the earlier discussion with respect to the direct bonded SiC substrate 200 as shown in Figure 2.

Unlike the direct bonded SiC substrate 200 as shown in Figure 2 in which the direct bonded SiC substrate 200 includes the monocrystalline SiC layer 202 being directly and physically bonded to the polycrystalline SiC base substrate 100, the direct bonded SiC substrate 218 as shown in Figure 3 includes a bonding layer 220 that is between the second surface 104 of the polycrystalline SiC base substrate 100 and the third surface 210 of the monocrystalline SiC layer 202. In some embodiments, the bonding layer 220 has a thickness ranging from 3 nanometers (nm) to 100 nanometers (nm), or is equal to the upper end or the lower end of this range.

For example, before the surface activated bonding (SAB) technique as discussed earlier herein is performed, a first conductive layer is formed on the second surface 104 of the polycrystalline SiC base substrate 100 and a second conductive layer is formed on the third surface 210 of the monocrystalline SiC layer 202 before the monocrystalline SiC layer 202 has been coupled to or bonded to the polycrystalline SiC base substrate 100. The first conductive layer and the second conductive layer is made of the same or different conductive materials that are suitable to be bonded together utilizing the SAB technique to further facilitate coupling or bonding together the polycrystalline SiC base substrate 100 to the monocrystalline SiC layer 202. In some situations, the first conductive layer and the second conductive layer, respectively, is formed on the second surface 104 of the polycrystalline SiC base substrate 100 and the third surface 210 of the monocrystalline SiC layer 202, respectively, by a sputtering technique or by some other technique suitable for forming the first conductive layer and the second conductive layer, respectively, on the second surface 104 of the polycrystalline SiC base substrate 100 and the third surface 210 of the monocrystalline SiC layer 202, respectively. For example, in some situations, when a material of the polycrystalline SiC base substrate 100 is not compatible with a material of the monocrystalline SiC layer 202, the bonding layer 220 is provided to facilitate coupling or bonding together the polycrystalline SiC base substrate 100 and the monocrystalline SiC layer 202.

In some embodiments, the first conductive layer and the second conductive layer are made of the same conductive material. In some embodiments, the first conductive layer and the second conductive layer are made of different conductive materials.

After the first and second conductive layers, respectively, have been formed on the second surface 104 of the polycrystalline SiC base substrate 100 and the third surface 210 of the monocrystalline SiC layer 202, respectively, the surface activated bonding technique is performed such that the first and second conductive layers are bombarded by Argon (Ar) ions or neutral atoms (*e.g.,* a beam of particles that is Argon (Ar), is neutral atoms, or is some other similar or like type of particle or atom that is suitable) in an ultra-high vacuum to clean and activate the first and second conductive layers, respectively, on the second surface 104 of the polycrystalline SiC base substrate 100 and on the third surface 210 of the monocrystalline SiC layer 202, respectively. After the first and second conductive layers are cleaned and activated, the first conductive layer on the second surface 104 of the polycrystalline SiC base substrate 100 and the second conductive layer on the third surface 210 of the monocrystalline SiC layer 202 are bonded spontaneously by contacting the first conductive layer on the second surface 104 of the polycrystalline SiC base substrate 100 with the second conductive layer on the third surface 210 of the monocrystalline SiC layer 202. This contacting of the first conductive layer on the second surface 104 of the polycrystalline SiC base substrate 100 with the second conductive layer on the third surface 210 of the monocrystalline SiC layer 202 can be done without heat treatment. Once the first conductive layer on the second surface 104 of the polycrystalline SiC base substrate 100 is bonded to the second conductive layer on the third surface 210 of the monocrystalline SiC layer 202, the bonding layer 220 between the polycrystalline layer 106 and the monocrystalline layer 202 is formed. In other words, the bonding layer 220 is a conductive layer formed by coupling the first conductive layer on the second surface 104 of the polycrystalline SiC base substrate 100 to the second conductive layer on the third surface 210 of the monocrystalline SiC layer 202.

In some alternative embodiments, instead of forming both the first and second conductive layers as discussed above, only one of the first or the second conductive layers is formed on only one of the second surface 104 of the polycrystalline SiC base substrate 100 or the third surface 210 of the monocrystalline SiC layer 202. After only one of the first or second conductive layers is formed, the SAB technique is carried out in the same or similar fashion as discussed earlier herein either with respect to Figure 2 or Figure 3 except that at least one of the second surface 104 of the polycrystalline SiC base substrate 100 or the third surface 210 of the monocrystalline SiC layer 202 remains uncovered and is exposed to the Argon or neutral atom beam.

Either both the first and second conductive layers or at least one of the first or second conductive layers can be formed to further strengthen or facilitate bonding or coupling together the polycrystalline SiC base substrate 100 and the monocrystalline SiC layer 202. For example, the bonding layer 220 being formed to couple or bond together the polycrystalline SiC base substrate 100 and the monocrystalline SiC layer 202 is stronger than when the bonding layer 220 is not present reducing the likelihood of mechanical defects propagating between the polycrystalline SiC base substrate 100 and the monocrystalline SiC layer 202.

When the bonding layer 220 is present between the second surface 104 of the polycrystalline SiC base substrate 100 and the third surface 210 of the monocrystalline SiC layer 202, the bonding layer 220 has a third thickness T3, which is referred to as a third dimension. The third thickness T3 extends from the second surface 104 of the polycrystalline SiC base substrate 100 to the third surface 210 of the monocrystalline SiC layer 202. The third thickness T3 is, in an embodiment, less than the first thickness T1. In at least some situations, the third thickness T3 of the bonding layer 220 is within the range from 0.2 micrometers (µm) to 5 micrometers (µm), or is equal to the upper and lower ends of this range (*e.g.,* the third thickness T3 is equal to 0.2 micrometers (µm) or is equal to 5 micrometers (µm)). In some embodiments, the third thickness is equal to 0.5 micrometers (µm).

In some situations, the second surface 104 of the polycrystalline SiC base substrate 100 has a roughness less than or equal to 200 nm. In some situations, the second surface 104 of the polycrystalline SiC base substrate 100 may have a roughness in a range from 10 nm to 50 nm, or is equal to the lower and upper ends of this range (*e.g.,* the roughness is equal to 10 nm or is equal to 50 nm). This roughness of the second surface 104 can be obtained by polishing the second surface 104.

In some situations, the third surface 210 of the monocrystalline SiC layer 202 has a roughness less than or equal to 200 nm. In some situations, the third surface 210 of the monocrystalline SiC layer 202 has a roughness in a range from 10 nm to 50 nm, or is equal to the lower and upper ends of this range (*e.g.,* the roughness is equal to 10 nm or is equal to 50 nm). This roughness of the third surface 210 can be obtained by polishing the third surface 210.

In some situations, the fourth surface 212 of the monocrystalline SiC layer 202 has a roughness less than or equal to 200 nm. In some situations, the fourth surface 212 of the monocrystalline SiC layer 202 has a roughness in a range from 10 nm and 50 nm, or is equal to the lower and upper ends of this range (*e.g.,* the roughness is equal to 10 nm or is equal to 50 nm). This roughness of the fourth surface 212 can be obtained by polishing or planarizing the fourth surface 212.

In some situations, a roughness at the first surface 102 of the polycrystalline SiC base substrate 100 is greater than or equal to the roughness of the second surface 104 of the polycrystalline SiC base substrate 100. This roughness of the first surface 102 can be obtained by polishing or planarizing the first surface 102.

In yet another alternative situation of the direct bonded SiC substrate 218, the bonding layer 220 is instead a monolayer of silicon. The monolayer of silicon includes the thickness T3 as shown in Figure 3. When the bonding layer 220 is the monolayer of silicon, the thickness T3 of the monolayer of silicon is within a range from 0.2 nanometers (nm) to 0.7 nanometers (nm), or is equal to the upper and lower ends of this range. The monolayer of silicon is formed on the second surface 104 of the polycrystalline SiC base substrate 100 when the monocrystalline SiC layer 202 is not very compatible with being directly and physically bonded to the second surface 104 of the polycrystalline SiC base substrate 100. The monolayer of silicon, which is to be the bonding layer 220, is formed by atomic layer deposition or sputtering resulting in the monolayer of silicon being present on the second surface 104 of the polycrystalline SiC base substrate 100 such that the monocrystalline SiC layer 202 is readily adhered to the polycrystalline SiC base substrate 100 through the monolayer of silicon, which again is the bonding layer 220. Alternatively, instead of the monolayer of silicon, the bonding layer 220 is a monolayer of carbon, a bilayer of carbon, or a layer of silicon dioxide (SiO₂). In some situations, the monolayer of carbon has a thickness within a range from 0.4 nanometers (nm) to 2 nanometers (nm), or is equal to the upper and lower ends of this range. In some situations, the bilayer of carbon has a thickness within a range from 1 nanometers (nm) to 5 nanometers (nm), or is equal to the upper and lower ends of this range. In some situations, the layer of SiO₂ has a thickness within a range from 2 nm (nanometers) to 7 nm (nanometers), or is equal to the upper and lower ends of this range.

Figure 4 is directed to a perspective view of an embodiment of a stacked assembly 300 in accordance with some embodiments of the present disclosure. The embodiment of the stacked assembly 300 includes the direct bonded SiC substrate 200 as shown in Figure 2. The stacked assembly 300 further includes one or more epitaxial layers 302 that are stacked on the direct bonded SiC substrate 200. As shown in Figure 2, the one or more epitaxial layers 302 are stacked on the fourth surface 212 of the monocrystalline SiC layer 202. In at least some embodiments, the one or more epitaxial layers 302 are SiC layers. In at least some embodiments, the one or more epitaxial layers 302 are silicon-carbide based layers, gallium nitride based layers, or some other suitable layer of material that is capable of being epitaxially formed or grown on the fourth surface 212 of the monocrystalline SiC layer 202.

When the one or more epitaxial layers 302 is only a single epitaxial layer 302 as shown in Figure 2, the single epitaxial layer 302 includes a fifth surface 304 and a sixth surface 306 opposite to the fifth surface 304. The fifth surface 304 faces towards the stacked assembly 300 and abuts the fourth surface 212 of the monocrystalline SiC layer 202 of the direct bonded SiC substrate 200. The sixth surface 306 faces away from the direct bonded SiC substrate 200. Based on the orientation of the stacked assembly 300 as shown in Figure 4, the sixth surface 306 is a respective upper surface of the stacked assembly 300 and the first surface 102 is a respective lower surface of the stacked assembly 300.

When the one or more epitaxial layers 302 are a plurality of epitaxial layers *(i.e.,* two or more epitaxial layers), the plurality of epitaxial layers 302 are stacked on the fourth surface 212 of the monocrystalline SiC layer 202, the fifth surface 304 is a respective surface of a respective lowermost epitaxial layer of the plurality of epitaxial layers 302, and the sixth surface 306 is a respective surface of a respective uppermost epitaxial layer of the plurality of epitaxial layers 302. Based on the orientation of the stacked assembly 300 as shown in Figure 4, the sixth surface 306 is a respective upper surface of the stacked assembly 300 and the first surface 102 is a respective lower surface of the stacked assembly 300.

The one or more epitaxial layers 302 of the stacked assembly 300 have a fourth thickness T4 that extends from the fifth surface 304 to the sixth surface 306. The fourth thickness T4 is within a range from 5 micrometers (µm) to 100 micrometers (µm), or is equal to upper and lower ends of this range.

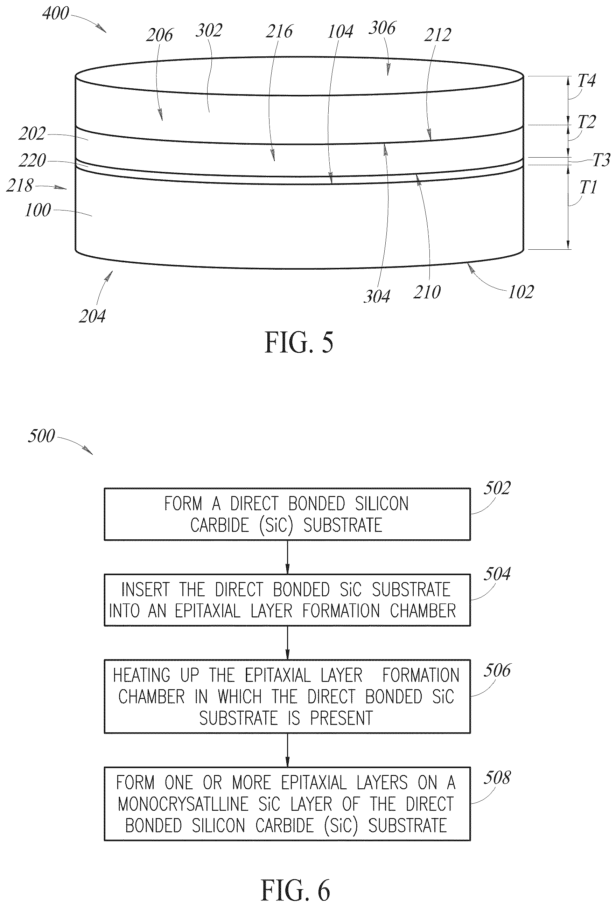

Figure 5 is a perspective view of an alternative embodiment of a stacked assembly 400 in accordance with some embodiments of the present disclosure. The stacked assembly 400 includes the alternative embodiment of the stacked assembly 400. The stacked assembly 400 further includes the one or more epitaxial layers 302. In other words, the alternative embodiment of the stacked assembly 400 as shown in Figure 4 is the same or similar to the stacked assembly 300 as shown in Figure 3, but, unlike the embodiment of the stacked assembly 300, the alternative embodiment of the stacked assembly 400 includes the alternative embodiment of the direct bonded SiC substrate 218 such that the bonding layer 220 is present in the alternative embodiment of the stacked assembly 400.

Figure 6 is a flowchart 500 of an embodiment of a method of manufacturing the embodiment of the stacked assembly 300 as shown in Figure 4 in accordance with some embodiments of the present disclosure. The flowchart 500 includes a first step 502, a second step 504, a third step 506, and a fourth step 508.

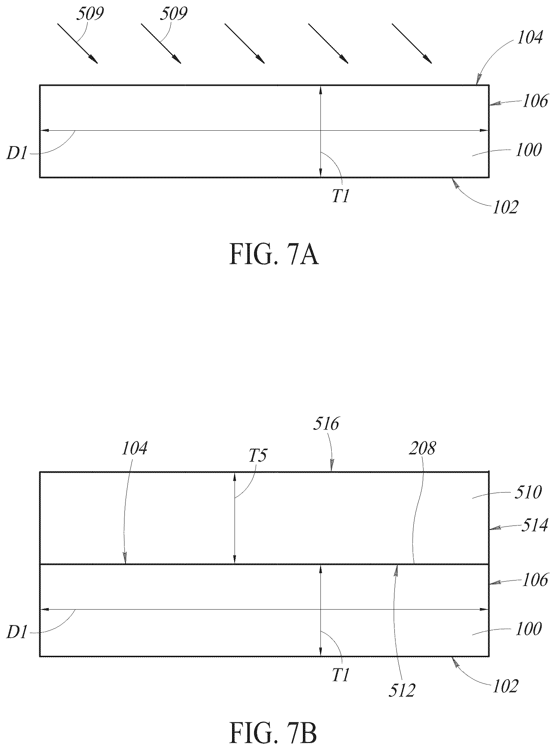

In the first step 502, the direct bonded SiC substrate 200 as shown in Figure 2 is formed. To form the direct bonded SiC substrate 200, the monocrystalline SiC layer 202 is formed on the second surface 104 of the polycrystalline SiC base substrate 100. To form the stacked assembly 300, the polycrystalline SiC base substrate 100 and a monocrystalline SiC substrate 510 (see Figure 7B) are formed. After the polycrystalline SiC base substrate 100 and the monocrystalline SiC substrate 510 have been formed, the polycrystalline SiC base substrate 100 and the monocrystalline SiC substrate 510 are utilized to form the embodiment of the stacked assembly 300 as shown in Figure 4.

In some embodiments, the polycrystalline SiC base substrate 100 is formed by introducing a carbon, silane, and nitrogen gas into a chamber of a chemical vapor deposition (CVD) tool to grow a polycrystalline material on a carrier present within a CVD chamber of the CVD tool, and, growing the polycrystalline material on the carrier results in the formation of the polycrystalline SiC base substrate 100 on the carrier. Once the polycrystalline SiC base substrate 100 has been grown on the carrier, the polycrystalline SiC base substrate 100 is removed from the carrier.

After the polycrystalline SiC base substrate 100 has been formed, the polycrystalline SiC base substrate 100 may undergo further processing techniques before being utilized to form the stacked assembly 300 as shown in Figure 4. For example, the second surface 104 of the polycrystalline SiC base substrate 100 is polished or planarized such that the second surface 104 of the polycrystalline SiC base substrate 100 has a roughness less than or equal to 200 nm. In some embodiments, the second surface 104 of the polycrystalline SiC substrate 100 may have a roughness in the range of 10 nm to 50 nm, or has a roughness that is equal to the lower or upper ends of this range (*e.g.,* the roughness is equal to 10 nm or is equal to 50 nm). After the second surface 104 of the polycrystalline SiC base substrate 100 has been polished or planarized, the polycrystalline SiC base substrate 100 may then be utilized to form the embodiment of the stacked assembly 300 as shown in Figure 4 in accordance with some embodiments of the present disclosure.

In some embodiments, the monocrystalline SiC substrate 510 (see Figure 6B) is formed utilizing a method known within the semiconductor industry. For example, the monocrystalline SiC substrate 510 is formed by melting high-purity, semiconductor-grade silicon and then utilizing a seed crystal to initiate formation of the monocrystalline SiC substrate 510.

After the polycrystalline SiC base substrate 100 and the monocrystalline SiC substrate 510 have been formed, in the first step 502, the polycrystalline SiC base substrate 100 and the monocrystalline SiC substrate 510 are coupled together as shown in Figure 7B of the present disclosure. In some embodiments, the polycrystalline SiC base substrate 100 and the monocrystalline SiC substrate 510 are coupled together utilizing a surface activated bonding (SAB) technique.

In at least one embodiment, when the SAB technique is utilized, the second surface 104 of the polycrystalline SiC base substrate 100 is exposed to a beam of neutral atoms or Argon (Ar) atoms as represented by arrows 509 as shown in Figure 7A to activate and clean the second surface 104 of the polycrystalline SiC base substrate 100. As discussed earlier herein, the second surface 104 of the polycrystalline SiC base substrate 100 may have been planarized to be substantially flat and level as well as polished to have a roughness less than or equal to 200 nm. In some embodiments, the second surface 104 of the polycrystalline SiC base substrate 100 may have a roughness in the range 10 nm to 50 nm, or equal to the lower and upper ends of this range (*e.g.,* a roughness is equal to 10 nm or is equal to 50 nm) before being exposed to the beam of neutral atoms or Argon (Ar) atoms.

In at least one embodiment, when the SAB technique is utilized, a respective surface 512 of the monocrystalline SiC substrate 510 is exposed to a beam of neutral atoms or Argon (Ar) atoms (not shown) to activate and clean the respective surface 512 of the monocrystalline SiC substrate 510. The respective surface 512 of the monocrystalline SiC substrate 510 may have been planarized to be substantially flat and level as well as polished to have a roughness less than or equal to 200 nm. In some embodiments, the respective surface 512 of the monocrystalline SiC substrate 510 may have a roughness in the range of 10 nm to 50 nm, or equal to the lower and upper ends of this range (*e.g.,* a roughness is equal to 10 nm or is equal to 50 nm) before being exposed to the beam of neutral atoms or Argon (Ar) atoms.

When the respective surface 512 of the monocrystalline SiC substrate 510 is polished before being coupled to or bonded to the second surface 104 of the polycrystalline SiC substrate 100, gaps or air gaps present along an interface at the bonding region 208 between the respective surface 512 of the monocrystalline SiC substrate 510 and the second surface 104 of the polycrystalline SiC substrate 100 are prevented. This provides better physical adhesion and contact between the second surface 104 of the polycrystalline substrate 100 and the respective surface 512 of the monocrystalline SiC substrate 510, as well as provides a stronger and more efficient electrical pathway between the polycrystalline SiC substrate 100 and the monocrystalline SiC substrate 100 at the interface between the second surface 104 of the polycrystalline SiC substrate 100 and the respective surface 512 of the monocrystalline SiC substrate 510.

After the second surface 104 of the polycrystalline SiC base substrate 100 and the respective surface 512 of the monocrystalline SiC substrate 510 are cleaned and activated, the monocrystalline SiC substrate 510 is flipped and the respective surface 512 of the monocrystalline SiC substrate 510, which is clean and activated, is contacted with the second surface 104 of the polycrystalline SiC base substrate 100, which is clean and activated, such that the clean and activated second surface 104 of the polycrystalline SiC base substrate 100 bonds with the clean and activated respective surface 512 spontaneously resulting in the monocrystalline SiC substrate 510 being bonded to the polycrystalline SiC base substrate 100 at the bonding region 208. When the monocrystalline SiC substrate 510 is bonded to the polycrystalline SiC base substrate 100, a sidewall 514 of the monocrystalline SiC substrate 510 is flush with the sidewall 106 of the polycrystalline SiC base substrate 100. The monocrystalline SiC substrate 510 has a fifth thickness T5 that extends from the respective surface 512 of the monocrystalline SiC substrate 510 to an opposing respective surface 516 of the monocrystalline SiC substrate 510 opposite to the respective surface 512 of the monocrystalline SiC substrate 510.

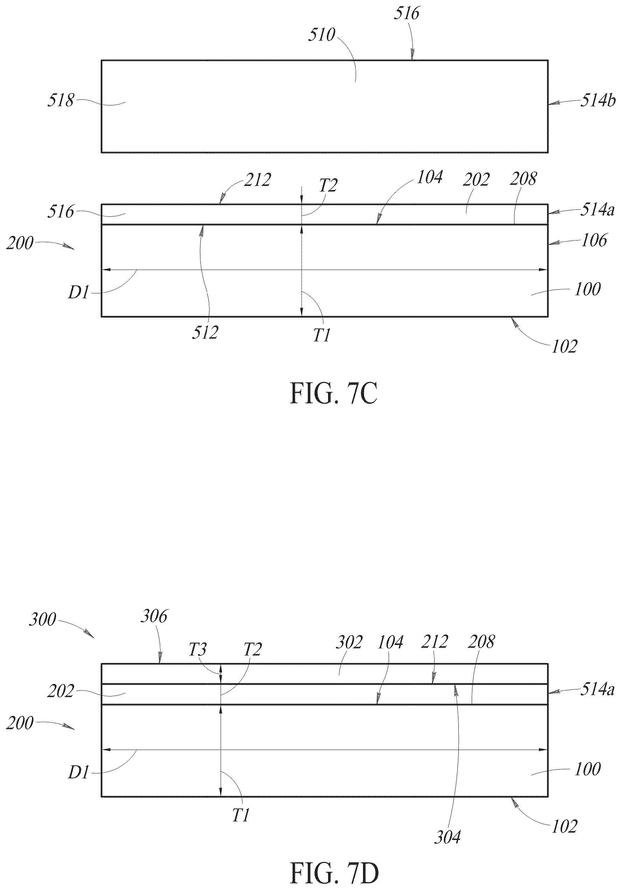

After the monocrystalline SiC substrate 510 has been bonded to the polycrystalline SiC base substrate 100 forming the bonding region 208 at which the respective surface 512 is bonded to the second surface 104 of the polycrystalline SiC base substrate 100, a second portion 518 of the monocrystalline SiC substrate 510 is removed from a first portion 517 of the monocrystalline SiC substrate 510 as shown in Figure 7C. The second portion 518 can be removed from the first portion 517 by slicing the monocrystalline SiC substrate 510 forming the first portion 517 and the second portion 518. After the second portion 518 has been removed from the first portion 517, the second portion 518 of the monocrystalline substrate 510 is utilized again to form another direct bonded SiC substrate 200 that is the same or similar to the direct bonded SiC substrate 200 as shown in Figure 2 of the present disclosure by, for example, bonding the second portion 518 of the monocrystalline SiC substrate 510 to another one of the polycrystalline SiC substrates 100. Removing the second portion 518 from the first portion 517 results in the sidewall 514 being broken up into a first sidewall 514a of the first portion 517 and a second sidewall 514b of the second portion 518. After the second portion 518 is removed, the first sidewall 514a of the first portion 517 of the monocrystalline SiC substrate 510 remains coplanar and flush with the sidewall 106 of the polycrystalline SiC base substrate 100. After the second portion 518 is removed, the first portion 517 remains bonded to the polycrystalline SiC base substrate 100 at the bonding region 208 resulting in the formation of the monocrystalline SiC layer 202 and the formation of the direct bonded SiC substrate 200 as shown in Figure 2 of the present disclosure. Removing the second portion 518 from the first portion 517 results in the formation of the fourth surface 212 of the monocrystalline SiC layer 202 as shown in Figure 7C.

After the removal of the second portion 518 from the first portion 516 of the monocrystalline SiC substrate 510 resulting in the formation of the monocrystalline SiC layer 202 on the second surface 104 of the polycrystalline SiC substrate 100, the monocrystalline SiC layer 202 is relatively level or flat. In at least one embodiment, the second surface of the monocrystalline layer 212 is polished to further refine, polish, flatten, or level the respective surface 212 of the monocrystalline SiC layer 212. By polishing or further refining the respective surface 212 of the monocrystalline SiC layer 202, any undulations, craters, or divots are further reduced or prevented entirely resulting in the monocrystalline SiC layer 202 being smooth, polished, flat, and level. By reducing or preventing these undulations, craters, or divots, any gaps or air gaps as discussed above are reduced in likelihood from occurring or are prevented from occurring at all when forming the epitaxial layer 302 on the respective surface 212 of the monocrystalline SiC layer 202.

After the first step 502 (see Figures 7B and 7C of the present disclosure) in which the direct bonded SiC substrate 200 has been formed including the polycrystalline SiC base substrate 100 and the monocrystalline SiC layer 202, in a second step 504 the direct bonded SiC substrate 200 is inserted into an epitaxial layer formation chamber of an epitaxial layer formation tool (not shown). The epitaxial layer formation tool is configured to, in operation, for the one or more epitaxial layers 302 of the stacked assembly 300 as discussed earlier herein and as shown in Figure 4 of the present disclosure.

After the second step 504 in which the direct bonded SiC substrate 200 has been inserted into the epitaxial layer formation chamber of the epitaxial layer formation tool, in a third step 506 the epitaxial layer formation chamber is heated up. For example, when the epitaxial layer formation chamber is heated up from a first temperature (*i.e.,* an idle temperature of the epitaxial layer formation chamber) to a second temperature. When the SiC substrate 200, which includes the monocrystalline SiC layer 202 having been formed on the second surface 104 of the polycrystalline SiC substrate 200, the monocrystalline SiC layer 202 has a thickness that is within the range 0.3 micrometers (µm) to 2 micrometers (µm), or is equal to the upper and lower ends of this range (*e.g.,* the second thickness T2 is equal to 0.3 micrometers (µm) or is equal to 2 micrometer (µm)). In some situations, the thickness of the monocrystalline SiC layer 202 is within the range of 0.3 micrometers (µm) to 1 micrometers (µm), or is equal to the upper and lower ends of this range (*e.g.,* the second thickness T2 is equal to 0.3 micrometers (µm) or is equal to 1 micrometer (µm)). In some situations, the thickness of the monocrystalline SiC layer 202 is equal to 0.5 micrometers (µm). In some situations, the thickness of the monocrystalline SiC layer 202 is within a range from 20 micrometers (µm) to 200 micrometers (µm), or is equal to the upper and lower ends of this range (*e.g.,* the second thickness T2 is equal to 20 micrometers (µm) or is equal to 200 micrometers (µm)). In some situations, the thickness of the monocrystalline SiC layer 202 is equal to 120 micrometers (µm). The thickness of the monocrystalline layer 202 is represented by the second thickness T2 as shown in Figures 7C and 7D.

In some embodiments, the first temperature is a room temperature, which is an idle temperature of the epitaxial layer formation chamber. The room temperature is within a range from 15 degrees Celsius (°C) to 25 degrees Celsius, or is equal to a lower end or an upper end of this range. The second temperature is within a range from 1500 degrees Celsius (°C) to 1680 degrees Celsius (°C), or is equal to the upper and lower ends of this range (*i.e.,* a temperature at which the one or more epitaxial layers is formed).

In some embodiments, the first temperature is within a range from 500 degrees Celsius (°C) to 950 degrees Celsius (°C), which is an idle temperature of the epitaxial layer formation chamber, or is equal to the upper or lower ends of this range. The second temperature is within a range from 1500 degrees Celsius (°C ) to 1680 degrees Celsius (°C), or is equal to the upper or lower ends of this range (*i.e.,* a temperature at which the one or more epitaxial layers is formed). When the first temperature is within the range from 500 degrees Celsius (°C) to 950 degrees Celsius (°C), this is referred to as "hot loading" and increases a speed at which the epitaxial layer formation chamber reaches the second temperature faster as compared to if the first temperature was instead at the room temperature.

In some embodiments, the first temperature is within a range from 600 degrees Celsius (°C) to 900 degrees Celsius (°C), which is an idle temperature of the epitaxial layer formation chamber, or is equal to the upper or lower end of this range. The second temperature is within a range from 1500 degrees Celsius (°C) to 1680 degrees Celsius (°C), or is equal to the upper or lower ends of this range. When the first temperature is within the range from 600 degrees Celsius (°C) to 900 degrees Celsius (°C), this is referred to as "hot loading" and increases a speed at which the epitaxial layer formation chamber reaches the second temperature faster as compared to if the first temperature was instead at the room temperature.

In some embodiments, when the hot loading technique is utilized, the SiC substrate 200 is allowed to reach the first temperature such that the SiC substrate is 'hot' before initiating any epitaxial layer formation growth as will be discussed later herein. When the hot loading technique is utilized, a respective temperature of the SiC substrate 200 has been heated to the first temperature within the epitaxial layer formation chamber. In other words, in this hot loading technique the SiC substrate 200 is brought up to an temperature that is equivalent to the first temperature within the epitaxial layer formation chamber.

In some situations, during this hot loading process in which the SiC substrate 200 is being heated up, the ethene gas is introduced during the hot loading process before the epitaxial layer formation process within the epitaxial layer formation chamber is initiated. This primes the epitaxial layer formation chamber with the ethene gas in advance of initiating the epitaxial formation process which further facilitates reducing or preventing deterioration of the monocrystalline SiC layer 202 present on and along the second surface 104 of the polycrystalline SiC substrate 100 during the epitaxial layer formation process.

In at least one embodiment, the second temperature is substantially equal to 1600 degrees Celsius (°C). For example, in some embodiments, during this second step 504, the epitaxial layer formation chamber is heated up from the first temperature to the second temperature when the direct bonded SiC substrate 200 is present within the epitaxial layer formation chamber. The heating up of the epitaxial layer formation chamber takes a first period of time. In some embodiments, this first period of time is approximately twelve (12) minutes. However, depending on the rate at which the epitaxial layer formation chamber is heated up, the first period of time is within a range from 30 seconds (s) to 15 minutes (mins), or is equal to the upper and lower ends of this range. The epitaxial layer formation chamber is heated up for this first period of time to 1600 °C is so that the epitaxial layer formation chamber equalizes in temperature such that the temperature of the entirety of the epitaxial layer formation chamber is substantially the same regardless of a respective location within the epitaxial layer formation chamber when the direct bonded SiC substrate 200 is present within the epitaxial layer formation chamber. In other words, the temperature distribution across the entirety of the epitaxial layer formation chamber is relatively the same regardless a respective location at which the temperature within the epitaxial layer formation chamber is measured while the direct bonded SiC substrate 200 is present within the epitaxial layer formation chamber.

After the third step 506 in which the epitaxial layer formation chamber of the epitaxial layer formation tool (not shown) has been heated up from the first temperature to the second temperature while the direct bonded SiC substrate 200 is present within the epitaxial layer formation chamber, in a fourth step 508 the one or more epitaxial layer 302 are formed on the fourth surface 212 of the monocrystalline SiC layer 202 of the direct bonded SiC substrate 200 the results of which are readily visible in Figure 7D. The one or more epitaxial layers 302 are formed on the fourth surface 212 of the monocrystalline SiC layer 202 of the direct bonded SiC substrate 200 by introducing at least one respective carry or susceptor gas and at least one other respective gas to result in one or more chemical reactions growing the one or more epitaxial layers 302 on the fourth surface 212 of the monocrystalline SiC layer 202 of the direct bonded SiC substrate 200. In some embodiments, when the one or more epitaxial layers 302 is only a single epitaxial layer, only a single carry or susceptor gas and a single other gas is introduced to form and grow the single epitaxial layer on the fourth surface 212 of the monocrystalline SiC layer 202 of the direct bonded SiC substrate 200. Alternatively, in some embodiments, when the one or more epitaxial layers 302 includes a plurality of epitaxial layers, then multiple carry or susceptor gases and multiple other gases are introduced successively to form and grow the plurality of epitaxial layers on the fourth surface 212 of the monocrystalline SiC substrate 200 and on each other such that respective epitaxial layers of the plurality of epitaxial layers are stacked on the fourth surface 212 and on each other, respectively. In some embodiments, it takes a second period of time to form the one or more epitaxial layers 302 after the first period of time in which the epitaxial layer formation chamber has been heated up from the first temperature to the second temperature. The second period of time ranges from 5 minutes (mins) to 60 minutes (mins), or is equal to the upper and lower ends of this range. In some embodiments, the ratio of the flowrates of the hydrogen gas and the ethene gas is within a range from 300 to 2,000, or is equal to the upper and lower ends of this range where the hydrogen gas flow rate is greater than the ethene gas flow rate.

For example, when the one or more epitaxial layers 302 is a single epitaxial layer as shown in Figure 7D, in some embodiments, the single epitaxial layer is formed by introducing a hydrogen gas (*e.g.,* an H₂ gas) and an ethene gas (*e.g.,* a C₂H₄ gas). In at least one embodiment, the hydrogen gas is introduced at a flow rate within a range from 120 to 220 liters per minute (L/min), or equal to the upper and lower ends of this range, and the ethene gas is introduced at a flowrate of within a range from 100 to 400 milliliters per minute (mL/min), or equal to the upper and lower ends of this range.

For example, in at least one embodiment, when the one or more epitaxial layers 302 is a single epitaxial layer, the hydrogen gas is introduced at a flowrate of 78 liters per minute (L/min), and the ethene gas is introduced at a flowrate within a range from 3.8 to 7.5 millimeters per minute (mL/min). In this at least one embodiment, it takes a second period of time to form the one or more epitaxial layers 302 after the first period of time in which the epitaxial layer formation chamber has been heated up from the first temperature to the second temperature. The second period of time ranges from 5 minutes (min) to 60 minutes (min), or is equal to the upper and lower ends of this range.

Generally, the carry or susceptor gas (*e.g.,* a hydrogen (H₂) gas) is introduced while the epitaxial layer formation chamber of the epitaxial layer formation tool in the second step 504 is being heated up before reaching and stabilizing at the second temperature. For example, when the epitaxial layer formation chamber is at a temperature within a range from 1,000 to 1,400 °C, or is equal to the upper and lower ends of this range, the carry or susceptor gas (*e*.*g*., hydrogen (H₂) gas) is introduced into the epitaxial layer formation chamber. In some embodiments, the carry or susceptor gas (*e.g.,* hydrogen (H₂) gas) is introduced before the second step 504 has started in which the epitaxial layer formation chamber is to be heated up from the first temperature to the second temperature.

Generally, once the epitaxial layer formation chamber has stabilized or equalized at the second temperature (*e.g.,* 1600 °C), the other gas (*e.g.,* ethene (C₂H₄) gas) is introduced into the epitaxial layer formation chamber to form or grow the one or more epitaxial layers 302 on the fourth surface 212 of the monocrystalline SiC layer 202 of the direct bonded SiC substrate 200 that is present within the epitaxial layer formation chamber. In some embodiments, the other gas (*e.g.,* ethene (C₂H₄) gas) is introduced slightly before the epitaxial layer formation chamber has stabilized and equalized at 1600 °C. For example, in some embodiments, the other gas (*e.g.,* ethene (C₂H₄) gas) is introduced once the epitaxial layer formation temperature is at or around 1550 °C or some other selected temperature slightly before the epitaxial layer formation chamber has stabilized and equalized at 1600 °C.

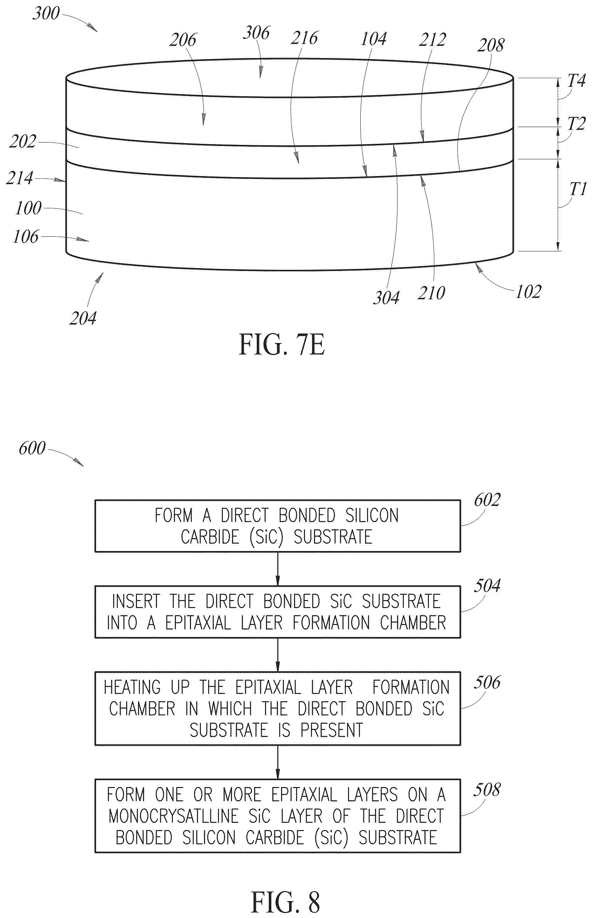

Generally, after the direct bonded SiC substrate 200 is exposed to the flow of the carry or susceptor gas or gases and the other gas or gases within the epitaxial layer formation chamber at the second temperature for the second period of time (*e.g.,* at least 20 minutes in some embodiments), the one or more epitaxial layers 302 have been formed or grown on the fourth surface 212 of the monocrystalline SiC layer 202 of the direct bonded SiC substrate 200. After the one or more epitaxial layers 302 have been formed on the fourth surface 212 of the monocrystalline SiC layer 202 of the direct bonded SiC substrate 200, the epitaxial layer formation chamber is allowed to cool and the flow of the carry or susceptor gas or gases and the other gas or gases is stopped. After allowing the epitaxial layer formation chamber to cool down, the stacked assembly 300 that is now formed as shown in Figures 7D and 7E is removed from the epitaxial layer formation chamber of the epitaxial layer formation tool.

Figure 8 is a flowchart 600 of an alternative embodiment of a method of manufacturing the alternative embodiment of the stacked assembly 400 as shown in Figure 5 in accordance with some embodiments of the present disclosure. The flowchart 600 includes a first step 602 that replaces the first step 502, and include the second step 504, the third step 506, and the fourth step 508. As there are similarities between the flowchart 500 as shown in Figure 6 and the flowchart 600 as shown in Figure 8, the following discussion will focus on the differences or additions of the flowchart 600 as shown in Figure 8 relative to the flowchart 500 as shown in Figure 6.

This alternative embodiment of the method of manufacturing the alternative embodiment of the stacked assembly 400 is the same or similar to the embodiment of the method of manufacturing the embodiment of the stacked assembly 300 as discussed earlier herein with respect to Figures 6 and 7A-7E. However, unlike forming the stacked assembly 300, forming the stacked assembly 400 includes forming a first conductive layer 604 on the second surface 104 of the polycrystalline SiC base substrate 100 in the first step 602 before performing the SAB technique to couple or bond together the polycrystalline SiC base substrate 100 and the monocrystalline SiC substrate 510. The first conductive layer 604 corresponds to the bonding layer 220.

In some embodiments, a second conductive layer (not shown) is formed on the respective surface 512 of the monocrystalline SiC substrate 510 before coupling or bonding together the polycrystalline SiC base substrate 100 and the monocrystalline SiC substrate 510. The first conductive layer 604 and the second conductive layer (not shown) are utilized to form the bonding layer 220.

Unlike the first step 502 in which the second surface 104 of the polycrystalline SiC base substrate 100 is exposed to the beam of neutral atoms or Argon (Ar) atoms as represented by arrows 509 when utilizing the SAB technique as discussed above to couple or bond together the polycrystalline SiC base substrate 100, the first conductive layer 604 is deposited onto the second surface 104 of the polycrystalline SiC base substrate 100 with respect to the first step 602. In some embodiments, the first conductive layer 604 is deposited onto the second surface 104 by a sputtering technique and is then polished or planarized. In some alternative embodiments, some other type of formation technique known to the semiconductor industry is utilized to form the first conductive layer 604 on the second surface 104 of the polycrystalline SiC base substrate 100.

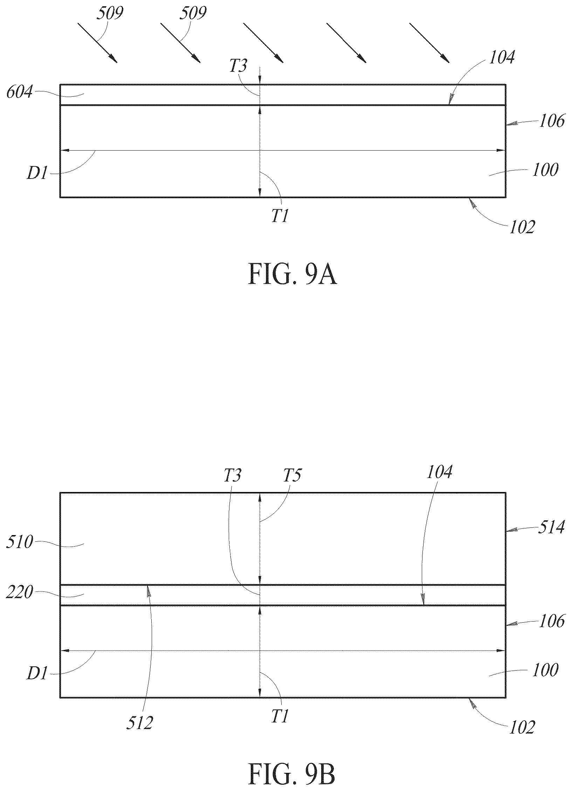

After the first conductive layer 604 has been formed, the first conductive layer 604 is exposed to the beam of neutral atoms or Argon (Ar) atoms as represented by arrows 509 as shown in Figure 9A. Similarly, the respective surface 512 of the monocrystalline SiC substrate 510 is exposed to the beam of neutral beam of neutral atoms or Argon (Ar) atoms as represented by arrows 509 to be cleaned and activated like the first conductive layer 604. Once the first conductive layer 604 and the respective surface 512 of the monocrystalline SiC substrate 510 are cleaned and activated, the monocrystalline SiC substrate 510 is flipped and the respective surface 512 of the monocrystalline SiC substrate 510, which is clean and activated, is contacted with the first conductive layer 604 on the second surface 104 of the polycrystalline SiC base substrate 100, which is clean and activated, such that the clean and activated first conductive layer 604 bonds with the clean and activated respective surface 512 spontaneously resulting in the monocrystalline SiC substrate 510 being bonded to the first conductive layer 604. The first conductive layer 604 forms the bonding layer 220.

In an alternative embodiment, a second conductive layer (not shown) is deposited and formed on the respective surface 512 of the monocrystalline SiC substrate 510 in the same or similar fashion as the first conductive layer 604 is deposited and formed on the second surface 104 of the polycrystalline SiC base substrate 100. After the second conductive layer is deposited and formed, the second conductive layer can be planarized or polished. Once the second conductive layer is deposited and formed and is planarized or polished, the second conductive layer is cleaned and activated by being exposed to the beam of neutral beam of neutral atoms or Argon (Ar). After the first conductive layer 604 on the second surface 104 of the polycrystalline SiC base substrate 100 and the second conductive layer (not shown) on the respective surface 512 of the monocrystalline SiC substrate, the monocrystalline SiC substrate 510 on which the second conductive layer (not shown) is present is flipped and the second conductive layer (not shown) on the respective surface 512 of the monocrystalline SiC substrate 510, which is clean and activated, is contacted with the first conductive layer 604 on the second surface 104 of the polycrystalline SiC base substrate 100, which is clean and activated, such that the clean and activated first conductive layer 604 bonds with the clean and activated second conductive layer (not shown) spontaneously resulting in the monocrystalline SiC substrate 510 being bonded to the polycrystalline SiC base substrate 100 by the bonding layer 220. When the first conductive layer 604 and the second conductive layer (not shown) are formed, the first conductive layer 604 and the second conductive layer form the bonding layer 220.

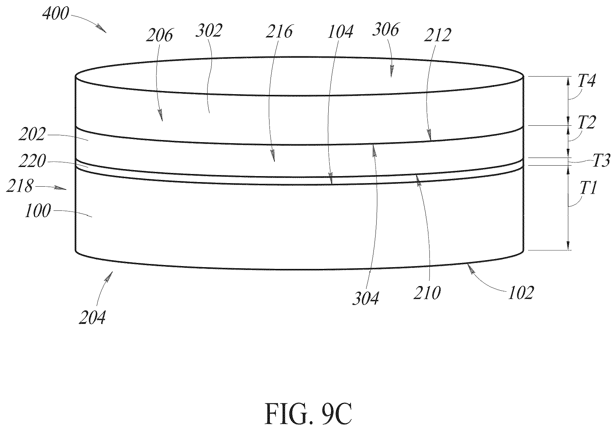

After the first step 602 has been completed, the second, third, and fourth steps 504, 506, 508 are carried out essentially in the same manner as discussed above resulting in the formation of the stacked assembly 400 as shown in Figure 9C. In other words, the second, third, and fourth steps 504 are the same, however, the bonding layer 220 is instead present.

When the respective embodiments of the methods of manufacturing as shown in the flowcharts 500, 600 of the present disclosure, a yield number of stacked assemblies 300, 400 that are manufactured are increased as the stacked assemblies 300, 400 are manufactured within desired tolerances for later use in formation of semiconductor devices or packages. For example, development and manufacture of silicon carbide based electronic devices are limited by factors such as electrical and mechanical properties from forming silicon carbide wafers. After being processed and refined, many manufactured silicon carbide wafers have one or more epitaxial layers formed on a respective surface of the silicon carbide wafers. For example, in direct bonded silicon-carbide (SiC) substrates, a monocrystalline SiC layer is bonded to a polycrystalline SiC substrate. After the monocrystalline layer has been bonded to the silicon-carbide substrate, one or more epitaxial layers are formed on the monocrystalline layer by placing the direct bonded SiC substrate, which includes the monocrystalline SiC layer bonded to the polycrystalline SiC substrate. The one or more epitaxial layers are formed by placing the direct bonded SiC substrate into an epitaxial growth chamber of an epitaxial layer formation tool. The epitaxial growth chamber is heated up to a selected temperature at which point a silicon-based gas, a carbon-based gas, and a hydrogen gas is introduced into the epitaxial growth chamber resulting in forming a silicon-carbide epitaxial layer on the monocrystalline SiC layer bonded to the polycrystalline SiC substrate of the direct bonded SiC substrate. However, while the epitaxial growth chamber in which the direct bonded SiC substrate is heated, the monocrystalline SiC layer is deteriorated, partially removed, or completely removed such that regions of a surface of the polycrystalline SiC layer are exposed from the monocrystalline SiC layer resulting in forming the epitaxial layer on the regions of the surface of the polycrystalline SiC layer exposed from the monocrystalline SiC layer. When the epitaxial layer is formed on these exposed regions, the epitaxial layer includes physical characteristics (*i.e.,* crystalline structure) of the polycrystalline SiC substrate at the regions exposed from the monocrystalline SiC layer. Alternatively, in some situations, the entirety of the monocrystalline SiC layer is deteriorated or removed resulting in an entirety of a surface of the polycrystalline SiC substrate on which the monocrystalline SiC layer was previously being exposed. In these situations, when the epitaxial layer is then formed, the epitaxial is completely formed on the surface of the polycrystalline SiC substrate as the monocrystalline SiC layer is no longer present. When the monocrystalline SiC substrate is partially removed or completely removed from the surface of the polycrystalline SiC substrate resulting in the epitaxial layer being formed directly on the surface of the polycrystalline substrate, the manufactured direct bonded SiC substrate is not within selected tolerances due to the epitaxial layer being in direct contact with the surface of the polycrystalline layer resulting in these manufactured directed bonded SiC substrate being waste and increasing yield loss. However, when the embodiments of the methods of manufacturing are utilized as discussed herein to form the stacked assemblies, the monocrystalline SiC layer 202 is only deteriorated by a small amount at most. For example, it has been found that the monocrystalline SiC layer 202 is deteriorated by 2% or less resulting in the entirety of the second surface 104 of the polycrystalline SiC base substrate 100 remains completely covered by the monocrystalline SiC layer 202. As the monocrystalline remains almost entirely intact on the second surface 104 of the polycrystalline SiC base substrate 100, the one or more epitaxial layers 302 are formed directly on the monocrystalline SiC layer 202 such that the one or more epitaxial layers 302 have physical characteristics corresponding to the monocrystalline SiC layer 202 instead of the polycrystalline SiC base substrate 100. The one or more epitaxial layers 302 having the physical characteristics corresponding to the monocrystalline SiC layer 202 is desired such that the final manufactured semiconductor packages or devices function within selected tolerances. In other words, by utilizing the embodiments of the methods of manufacturing the stacked assemblies 300, 400 as discussed herein there is no diffusion between the one or more epitaxial layer 302 and the polycrystalline SiC base substrate 100 as the monocrystalline SiC layer 202 remains completely intact when manufacturing the embodiments of the stacked assemblies 300, 400 of the present disclosure.

In an attempt to prevent deterioration of the monocrystalline SiC layer 202 when forming the stacked assemblies 300, 400 of the present disclosure, it is possible to reduce the second temperature within the epitaxial layer formation chamber as discussed herein to only reach a temperature of 1400 °C. However, it was found that when the second temperature is only allowed to reach the temperature of 1400 °C the likelihood of mechanical defects or a number of mechanical defects that occur within the monocrystalline SiC layer 202 is larger. In other words, while there is a lower deterioration rate or etching rate of the monocrystalline SiC layer 202 when exposed to the 1400 °C, there is a greater number of mechanical defects as compared to when the second temperature is instead selected to be 1600 °C. Accordingly, in view of the above discussion, the embodiments of the methods of manufacturing the stacked assemblies (*see, e.g.,* the flowcharts 500, 600 as shown in Figures 6 and 8 of the present disclosure) balance the deterioration or etching of the monocrystalline SiC layer 202 and preventing the propagation of defects within the monocrystalline SiC layer 202 increasing the yield number of the stacked assemblies 300, 400 being within selected tolerances to then be utilized to form semiconductor devices or packages by further processing within a semiconductor manufacturing plant (FAB).

Furthermore, the 'hot loading' technique as discussed earlier herein is utilized in the method of manufacturing 600. Also, the ethene gas may similarly be introduced into the epitaxial layer formation chamber during the 'hot loading' process and heating of the direct bonded SiC substrate 200 to the respective temperature within the epitaxial layer formation chamber.

In view of the above discussion, by utilizing the embodiments of the method of manufacturing 500, 600 the stacked assemblies 300, 400, the monocrystalline SiC layer 202 remains completely intact or is only deteriorated by a small amount (*e*.*g*., less than 2%) such that the monocrystalline SiC layer 202 completely cover the second surface 104 or the bonding layer 220 of the embodiments of the stacked assemblies 300, 400, respectively, completely preventing diffusion of the one or more epitaxial layers 302 into the polycrystalline SiC base substrate 100. In other words, the monocrystalline SiC layer 202 is capable of properly acting as a barrier layer preventing the one or more epitaxial layers 302 from being formed directly on the second surface 104 of the polycrystalline SiC base substrate 100 or the bonding layer 220 when present increasing the yield number of usable stacked assemblies 300, 400 that can be further processed or utilized to form semiconductor devices or packages that will function within desired tolerances. Furthermore, it has been found that since the monocrystalline SiC layer 202 is deteriorated by less than 2%, the thickness of the monocrystalline SiC layer remains substantially the same between when being inserted into the epitaxial layer formation chamber of the epitaxial layer formation tool and after one or more epitaxial layers have been formed on the respective surface 212 of the monocrystalline SiC substrate 202. For example, when the substrate 200 is inserted into the epitaxial layer formation chamber, the monocrystalline SiC layer 202 has a thickness that is within a range from 0.2 to 1.5 micrometers (µm), or is equal to a lower end or an upper end of this range, and, after the one or more epitaxial layers 302 have been formed on the respective surface 212 of the monocrystalline SiC layer 202, the thickness of the monocrystalline SiC layer 202 is the substantially the same or equal to the thickness when the substrate 200 was inserted into the epitaxial layer formation chamber. As it has been found that the thickness of the monocrystalline SiC layer 202 remains the same during the entirety of forming respective epitaxial layers on the respective surface 212 of the monocrystalline SiC layer 202 utilizing the embodiments of the methods 500, 600 as discussed herein, after the one or more epitaxial layers 302 are formed on the respective surface 212 of the monocrystalline SiC layer 202, the monocrystalline SiC layer 202 completely and fully separates the one or more epitaxial layers 302 from the second surface 104 of the polycrystalline SiC substrate 100..

As discussed above, by reducing a size of the undulations, craters, or divots or by preventing the undulations, craters, or divots altogether, this prevents or reduces the likelihood of any holes from forming within the monocrystalline SiC layer 202 when forming the one or more epitaxial layers 302 on the respective surface 212 of the monocrystalline SiC layer 202. For example, in conventional epitaxial formation techniques, there is a high likelihood that craters, undulations, or divots being present along a respective surface of the respective monocrystalline layer become holes that expose regions of a respective surface of a polycrystalline layer on which the respective monocrystalline layer is present. This hole in the respective monocrystalline layer exposing the region of the polycrystalline substrates results in the respective epitaxial layer being formed on the respective monocrystalline layer filling the hole such that the respective epitaxial layer is in direct contact with the polycrystalline layer in an unintended fashion and resulting in a respective surface of the epitaxial layer having a crater, a divot, or an undulation formed at a region of the respective epitaxial layer overlapping the hole filled by the respective epitaxial layer. In view of this discussion, the monocrystalline layer 202 remaining intact during the entirety of the either embodiment of the method 500, 600 prevents these defects as no holes are formed in the monocrystalline layer 202 since the monocrystalline layer 202 remains completely intact and fully covers the respective surface 212 of the monocrystalline layer 202.

Furthermore, as the monocrystalline layer 202 remains completely and fully intact during the methods 500, 600, the epitaxial layer 302 adopts respective physical characteristics of the monocrystalline SiC layer 202 as desired across their entirety unlike when a hole is present in the respective monocrystalline layer at which the respective epitaxial layer adopts the physical characteristics of the respective polycrystalline substrate. In other words, reducing or preventing the craters, divots, or undulations, prevents or reduces the likelihood of any holes propagating within the monocrystalline layer 202 during the methods 500, 600 such that the epitaxial layer 302 only adopts the physical characteristics of the monocrystalline layer 202 as intended instead of adopting the physical characteristics of the polycrystalline SiC substrate 2000, which is undesired or unintended and results in a defect region formed along the epitaxial layer 302 at which it has physical characteristics of the polycrystalline SiC substrate 200 instead of the monocrystalline SiC layer 202.

At least some embodiments of a method of manufacturing of the present disclosure includes: forming a direct bonded SiC substrate including: forming a polycrystalline SiC substrate including a first surface and a second surface opposite to the first surface; forming a monocrystalline SiC substrate including a third surface and a fourth surface opposite to the third surface; bonding the monocrystalline SiC substrate to the polycrystalline SiC substrate; after bonding the monocrystalline SiC substrate to the polycrystalline SiC substrate, removing a first portion of the monocrystalline SiC substrate leaving a second portion remaining bonded to the polycrystalline SiC substrate forming a monocrystalline SiC layer stacked on the polycrystalline SiC substrate, the monocrystalline SiC layer fully and completely overlaps the polycrystalline SiC substrate; forming one or more epitaxial layers on the monocrystalline SiC layer stacked on the polycrystalline SiC substrate including: inserting the direct bonded SiC substrate into an epitaxial layer formation chamber of an epitaxial layer formation tool; heating up the epitaxial layer formation temperature from a first temperature to a second temperature; and introducing a carry gas into the epitaxial layer formation chamber and another gas into the epitaxial layer formation chamber forming the one or more epitaxial layers on the monocrystalline SiC layer after forming the one or more epitaxial layers on the monocrystalline SiC layer, removing a stacked assembly from the epitaxial layer formation chamber, and the stacked assembly includes the polycrystalline SiC substrate, the monocrystalline SiC layer, and the one or more epitaxial layers in a stacked configuration.

In some embodiments, the first temperature is a room temperature, which is an idle temperature, and the second temperature is within a range from 1500 degrees Celsius (°C ) to 1680 degrees Celsius (°C), or is equal to upper and lower ends of this range.

In some embodiments, the first temperature is within a range from 500 degrees Celsius (°C) to 950 degrees Celsius (°C) , or is equal to the upper or lower ends of this range; and the second temperature is within a range from 1500 degrees Celsius (°C) to 1680 degrees Celsius (°C), or is equal to the upper or lower ends of this range.

In some embodiments, bonding the monocrystalline SiC substrate to the polycrystalline substrate further includes performing a surface activated bonding (SAB) technique to directly and physically bond the second surface of the polycrystalline SiC substrate to the third surface of the monocrystalline SiC substrate.

In some embodiments, performing the surface activated bonding (SAB) technique to directly and physically bond the second surface of the polycrystalline SiC substrate to the third surface of the monocrystalline SiC substrate includes: exposing the second surface of the polycrystalline SiC substrate to a beam of neutral atoms activating and cleaning the second surface of the polycrystalline SiC substrate; exposing the third surface of the monocrystalline SiC substrate to a beam of neutral atoms activating and cleaning the third surface of the monocrystalline SiC substrate; after exposing the second surface of the polycrystalline SiC substrate and the third surface of the monocrystalline SiC substrate to the beam of neutral atoms, directly and physically contacting the second surface of the polycrystalline SiC substrate to the third surface of the monocrystalline SiC substrate spontaneously bonding the second surface of the polycrystalline SiC substrate directly and physically to the third surface of the monocrystalline SiC substrate.

In some embodiments, the second portion has a thickness within a range from 5 micrometers (µm) to 100 micrometers (µm), or equal to upper and lower ends of this range.

In some embodiments, forming the direct bonded SiC substrate further includes: forming a first conductive layer on the second surface of the polycrystalline SiC substrate; bonding the monocrystalline SiC substrate to the polycrystalline SiC substrate further includes directly and physically bonding the third surface of the monocrystalline SiC substrate to the first conductive layer.

In some embodiments, bonding the monocrystalline SiC substrate to the polycrystalline substrate further includes performing a surface activated bonding (SAB) technique to directly and physically bond the first conductive layer on the second surface of the polycrystalline SiC substrate to the third surface of the monocrystalline SiC substrate

In some embodiments, performing the surface activated bonding (SAB) technique to directly and physically bond the first conductive layer on the second surface of the polycrystalline SiC substrate to the third surface of the monocrystalline SiC substrate includes: exposing the first conductive layer on the second surface of the polycrystalline SiC substrate to a beam of neutral atoms activating and cleaning the first conductive layer on the second surface of the polycrystalline SiC substrate; exposing the third surface of the monocrystalline SiC substrate to a beam of neutral atoms activating and cleaning the third surface of the monocrystalline SiC substrate; after exposing the first conductive layer on the second surface of the polycrystalline SiC substrate and the third surface of the monocrystalline SiC substrate to the beam of neutral atoms, directly and physically contacting the first conductive layer on the second surface of the polycrystalline SiC substrate to the third surface of the monocrystalline SiC substrate spontaneously bonding the first conductive layer on the second surface of the polycrystalline SiC substrate directly and physically to the third surface of the monocrystalline SiC substrate

In some embodiments, forming the direct bonded SiC substrate further includes: forming a first conductive layer on the second surface of the polycrystalline SiC substrate; and forming a second conductive layer on the third surface of the polycrystalline SiC substrate; bonding the monocrystalline SiC substrate to the polycrystalline SiC substrate further includes directly and physically bonding the second conducive layer to the first conductive layer.

In some embodiments, bonding the monocrystalline SiC substrate to the polycrystalline substrate further includes performing a surface activated bonding (SAB) technique to directly and physically bond the first conductive layer on the second surface of the polycrystalline SiC substrate to the second conducive layer on the third surface of the monocrystalline SiC substrate

In some embodiments, performing the surface activated bonding (SAB) technique to directly and physically bond the first conductive layer on the second surface of the polycrystalline SiC substrate to the second conductive layer on the third surface of the monocrystalline SiC substrate includes: exposing the first conductive layer on the second surface of the polycrystalline SiC substrate to a beam of neutral atoms activating and cleaning the first conductive layer on the second surface of the polycrystalline SiC substrate; exposing the second conductive layer on the third surface of the monocrystalline SiC substrate to a beam of neutral atoms activating and cleaning the second conductive layer on the third surface of the monocrystalline SiC substrate; after exposing the first conductive layer on the second surface of the polycrystalline SiC substrate and the second conductive layer on the third surface of the monocrystalline SiC substrate to the beam of neutral atoms, directly and physically contacting the first conductive layer on the second surface of the polycrystalline SiC substrate to the second conductive layer on the third surface of the monocrystalline SiC substrate spontaneously bonding the first conductive layer on the second surface of the polycrystalline SiC substrate directly and physically to the second conductive layer on the third surface of the monocrystalline SiC substrate.

At least some embodiments of a device of the present disclosure includes: a polycrystalline SiC substrate including a first surface and a second surface opposite to the first surface; a monocrystalline SiC layer directly and physically bonded to the second surface of the polycrystalline SiC substrate; one or more epitaxial layers on the monocrystalline SiC layer, the one or more epitaxial layers are completely and fully separate and spaced apart from the polycrystalline SiC substrate by the monocrystalline SiC layer.

In some embodiments, the one or more epitaxial layers have physical characteristics corresponding to the monocrystalline SiC layer.

In some embodiments, the monocrystalline SiC layer has a thickness within a range from 0.2 micrometers (µm) to 1.5 micrometers (µm), or equal to an upper end and a lower end of the range.

At least some embodiments a device of the present disclosure includes: a polycrystalline SiC substrate including a first surface and a second surface opposite to the first surface; a bonding layer on second surface of the polycrystalline SiC substrate; a monocrystalline SiC layer stacked on the bonding layer; and one or more epitaxial layers stacked on the monocrystalline SiC layer, the one or more epitaxial layers are separate and spaced apart from the polycrystalline SiC substrate by the monocrystalline layer and the bonding layer.

In some embodiments, the bonding layer includes a first conductive material.

In some embodiments, the bonding layer includes a second conductive material different from the first conductive material.

In some embodiments, the monocrystalline layer has a thickness within a range from 0.2 micrometers (µm) to 1.5 micrometers (µm), or equal to upper and lower ends of this range.

In some embodiments, the bonding layer has a thickness within a range from 3 nanometers (nm) to 100 nanometers (nm), or equal to upper and lower ends of this range.

The various embodiments described above can be combined to provide further embodiments. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A method of manufacturing, comprising the steps of:
forming (502; 602) a direct bonded SiC substrate (200) including:
forming a polycrystalline SiC substrate (100) including a first surface (102) and a second surface (104) opposite to the first surface;
forming a monocrystalline SiC substrate (202) including a third surface (210) and a fourth surface (212) opposite to the third surface;
bonding the monocrystalline SiC substrate to the polycrystalline SiC substrate;
after bonding the monocrystalline SiC substrate to the polycrystalline SiC substrate, removing a first portion of the monocrystalline SiC substrate leaving a second portion remaining bonded to the polycrystalline SiC substrate forming a monocrystalline SiC layer stacked on the polycrystalline SiC substrate, the monocrystalline SiC layer fully and completely overlaps the polycrystalline SiC substrate;
forming (504-508; 604-608) one or more epitaxial layers (302) on the monocrystalline SiC layer stacked on the polycrystalline SiC substrate including:
inserting (504; 604) the direct bonded SiC substrate into an epitaxial layer formation chamber of an epitaxial layer formation tool;
heating up (506; 606) the epitaxial layer formation temperature from a first temperature to a second temperature; and
introducing a carry gas into the epitaxial layer formation chamber and another gas into the epitaxial layer formation chamber forming the one or more epitaxial layers on the monocrystalline SiC layer
after forming the one or more epitaxial layers on the monocrystalline SiC layer, removing a stacked assembly from the epitaxial layer formation chamber, and the stacked assembly includes the polycrystalline SiC substrate, the monocrystalline SiC layer, and the one or more epitaxial layers in a stacked configuration.

2. The method of claim 1, wherein the first temperature is a room temperature and the second temperature is within a range from 1500 degrees Celsius to 1680 degrees Celsius, or is equal to upper and lower ends of this range.

3. The method of claim 1, wherein:
the first temperature is within a range from 500 degrees Celsius to 950 degrees Celsius, or is equal to the upper or lower ends of this range; and
the second temperature is within a range from 1500 degrees Celsius to 1680 degrees Celsius, or is equal to the upper or lower ends of this range.

4. The method of claim 1, wherein bonding the monocrystalline SiC substrate to the polycrystalline substrate further includes performing a surface activated bonding, SAB, technique to directly and physically bond the second surface of the polycrystalline SiC substrate to the third surface of the monocrystalline SiC substrate.

5. The method of claim 4, wherein performing the surface activated bonding, SAB, technique to directly and physically bond the second surface (104) of the polycrystalline SiC substrate (100) to the third surface (210) of the monocrystalline SiC substrate (202) includes:
exposing the second surface (104) of the polycrystalline SiC substrate to a beam of neutral atoms activating and cleaning the second surface of the polycrystalline SiC substrate;
exposing the third surface (210) of the monocrystalline SiC substrate to a beam of neutral atoms activating and cleaning the third surface of the monocrystalline SiC substrate; and
after exposing the second surface (104) of the polycrystalline SiC substrate and the third surface (210) of the monocrystalline SiC substrate to the beam of neutral atoms, directly and physically contacting the second surface of the polycrystalline SiC substrate to the third surface of the monocrystalline SiC substrate spontaneously bonding the second surface of the polycrystalline SiC substrate directly and physically to the third surface of the monocrystalline SiC substrate.

6. The method of claim 1, wherein the second portion has a thickness within a range from 5 micrometers to 100 micrometers, or equal to upper and lower ends of this range.

7. The method of claim 1, wherein:
forming the direct bonded SiC substrate further includes:
forming a first conductive layer (604) on the second surface (104) of the polycrystalline SiC substrate (100); and
bonding the monocrystalline SiC substrate to the polycrystalline SiC substrate further includes directly and physically bonding the third surface of the monocrystalline SiC substrate to the first conductive layer.

8. The method of claim 7, wherein bonding the monocrystalline SiC substrate (202) to the polycrystalline substrate (100) further includes performing a surface activated bonding, SAB, technique to directly and physically bond the first conductive layer on the second surface (104) of the polycrystalline SiC substrate to the third surface (210) of the monocrystalline SiC substrate.

9. The method of claim 8, wherein performing the surface activated bonding, SAB, technique to directly and physically bond the first conductive layer (604) on the second surface (104) of the polycrystalline SiC substrate (100) to the third surface (210) of the monocrystalline SiC substrate (202) includes:
exposing the first conductive layer on the second surface of the polycrystalline SiC substrate to a beam of neutral atoms activating and cleaning the first conductive layer on the second surface of the polycrystalline SiC substrate;
exposing the third surface of the monocrystalline SiC substrate to a beam of neutral atoms activating and cleaning the third surface of the monocrystalline SiC substrate; and
after exposing the first conductive layer on the second surface of the polycrystalline SiC substrate and the third surface of the monocrystalline SiC substrate to the beam of neutral atoms, directly and physically contacting the first conductive layer on the second surface of the polycrystalline SiC substrate to the third surface of the monocrystalline SiC substrate spontaneously bonding the first conductive layer on the second surface of the polycrystalline SiC substrate directly and physically to the third surface of the monocrystalline SiC substrate.

10. The method of claim 1, wherein forming the direct bonded SiC substrate (200) further includes the steps of:
forming a first conductive layer (604) on the second surface (104) of the polycrystalline SiC substrate (100); and
forming a second conductive layer on the third surface (210) of the monocrystalline SiC substrate (202);
bonding the monocrystalline SiC substrate to the polycrystalline SiC substrate further includes directly and physically bonding the second conducive layer to the first conductive layer.

11. The method of claim 10, wherein bonding the monocrystalline SiC substrate to the polycrystalline substrate further includes performing a surface activated bonding, SAB, technique to directly and physically bond the first conductive layer on the second surface of the polycrystalline SiC substrate to the second conducive layer on the third surface of the monocrystalline SiC substrate.

12. The method of claim 11, wherein performing the surface activated bonding, SAB, technique to directly and physically bond the first conductive layer on the second surface of the polycrystalline SiC substrate to the second conductive layer on the third surface of the monocrystalline SiC substrate includes:
exposing the first conductive layer (604) on the second surface (104) of the polycrystalline SiC substrate (100) to a beam of neutral atoms activating and cleaning the first conductive layer on the second surface of the polycrystalline SiC substrate;
exposing the second conductive layer on the third surface (210) of the monocrystalline SiC substrate (202) to a beam of neutral atoms activating and cleaning the second conductive layer on the third surface of the monocrystalline SiC substrate; and
after exposing the first conductive layer on the second surface of the polycrystalline SiC substrate and the second conductive layer on the third surface of the monocrystalline SiC substrate to the beam of neutral atoms, directly and physically contacting the first conductive layer on the second surface of the polycrystalline SiC substrate to the second conductive layer on the third surface of the monocrystalline SiC substrate spontaneously bonding the first conductive layer on the second surface of the polycrystalline SiC substrate directly and physically to the second conductive layer on the third surface of the monocrystalline SiC substrate.

13. A device, comprising:
a polycrystalline SiC substrate (100) including a first surface (102) and a second surface (104) opposite to the first surface;
a monocrystalline SiC layer (202) bonded to the second surface of the polycrystalline SiC substrate,; and
one or more epitaxial layers on the monocrystalline SiC layer, the one or more epitaxial layers being separate and spaced apart from the polycrystalline SiC substrate by the monocrystalline SiC layer.

14. The device of claim 13, wherein the monocrystalline SiC layer is directly and physically bonded to the second surface of the polycrystalline SiC substrate,the monocrystalline SiC layer fully and completely covering the second surface of the polycrystalline SiC substrate; and
the one or more epitaxial layers (302) on the monocrystalline SiC layer, the one or more epitaxial layers are completely and fully separate and spaced apart from the polycrystalline SiC substrate by the monocrystalline SiC layer.

15. The device of claim 13, further comprising a bonding layer (220) on second surface (104) of the polycrystalline SiC substrate (100);
wherein:
the monocrystalline SiC layer (202) is stacked on the bonding layer (220);
the one or more epitaxial layers (302) are stacked on the monocrystalline SiC layer, and are separate and spaced apart from the polycrystalline SiC substrate by the monocrystalline layer and the bonding layer;
and wherein:
the bonding layer (220) includes a first conductive material (604); alternatively wherein:
the bonding layer (220) includes a first conductive material (604) and a second conductive layer of a material different from a material of the first conductive material.
